# EUROPEAN PATENT SPECIFICATION

(11) **EP 0 822 579 B1**
(45) Date of publication and mention of the grant of the patent: **21.07.2004**
(21) Application number: 96830437.8
(22) Date of filing: 31.07.1996
(51) Int. Cl.: H01L 21/00, H01L 21/762, H01L 21/764

(54) **Intergrated microstructures and a method of fabricating thereof**
Integrierte Mikrostrukturen aus Halbleitermaterial und ein Verfahren zu deren Herstellung
Des structures intégrés d'un matériau semi-conducteur et un procédé pour leur fabrication

(43) Date of publication of application: 04.02.1998
(73) Proprietor: STMicroelectronics S.r.l., 20041 Agrate Brianza (Milano) (IT)
(72) Inventor: Foroni, Mario, 37067 Valeggio Sul Mincio (IT); Ferrari, Paolo, 21013 Gallarate (IT); Vigna, Benedetto, 85100 Potnza (IT); Villa, Flavio, 20159 Milano (IT)
(74) Representative: Cerbaro, Elena, Dr.

(56) References cited:
- EP-A- 0 624 900
- WO-A-91/16608
- WO-A-92/22820
- DE-A- 4 341 271
- US-A- 4 744 863
- US-A- 5 095 401
- US-A- 5 369 544
- MICROELECTRONICS JOURNAL, vol. 25, no. 3, 1 May 1994, pages 145-156, XP000453703 STOFFEL A M: "MICROMACHINING AND ASIC TECHNOLOGY"

## Description

The present invention relates to a method of fabricating integrated microstructures of semiconductor material.

As is known, micromachining, based on fabrication technologies typical of microelectronics, provides for fabricating microsystems such as microsensors, microactuators and special micromechanisms using the know-how and advantages typical of microelectronics processes.

In the past, such microstructures have preferably been fabricated by bulk micromachining, whereby a silicon wafer is processed on both faces to exploit the excellent mechanical properties of monocrystalline silicon. Front-rear processing, however, and the need for particular handling of the wafers make bulk micromachining incompatible with current integrated circuit fabrication technology.

Another microsystem fabrication technique employs etching solutions such as ethyldiaminapyrocatechol (EDP), and the structure is formed and separated from the substrate by etching the massive silicon from the front of the wafer using what is known as the "front bulk micromachining" technique.

In the mid 80s, what is known as "surface micromachining" was proposed, whereby the sensitive element or micromechanism is formed of polycrystalline silicon, and which provides for forming suspended structures by depositing and subsequently removing sacrificial layers of different types, e.g. silicon oxide or nitride, porous silicon, aluminium, photoresist, polyimide, etc. An example of this technique is described in US-A-4 744 863.

A general review of surface micromachining technology (as well as bulk micromachining and the characteristics of each) is to be found, for example, in the article entitled "Micromachining and ASIC technology" by Axel M. Stoffel, in Microelectronics Journal, 25 (1994), p. 145-156.

Surface micromachined suspended structures, however, are characterized by poor flexural rigidity, and a tendency to collapse on to the underlying layer, thus impairing thermal or mechanical isolation.

In the early 90s, a further microstructure fabrication technique, known as "silicon fusion bonding", was devised, whereby a cavity is formed in a monocrystalline silicon wafer onto which a further monocrystalline silicon wafer, in which the sensor is formed, is bonded.

A similar microstructure fabrication technique employs dedicated or nondedicated SOI (silicon-on-Insulator) substrates. An example of this technique is described in US-A-5 369 544, to which the preambles of claims 1 and 12 refer.

Other highly specialized techniques, such as "wafer dissolving", provide for forming silicon microstructures by means of dedicated processes which are totally incompatible with standard planar microelectronics technology. In a sense, these "ad hoc" processes simply consist in transferring on to silicon what is currently done using other materials, and only provide for fabricating the sensitive portion, so that the processing and control circuit must be formed on a separate chip.

Yet another highly specialized technique is the LIGA method - a German acronym for Lithographie Galvanoformung Abformung - which comprises three processing steps: synchrotron x-ray lithography; galvanic deposition of metal films; and formation of plastic molds (see, for example, S.M.Sze's "Semiconductor Sensors", John Wiley & Sons, Inc., Chapter 2, p. 75-78).

None of the above methods, however, provides for fabricating low-cost sensors comparable with those of microelectronics technology, using known, highly controllable, noncritical fabrication steps, and which may be integrated with the control electronics in one chip.

It is an object of the present invention to provide a method of fabricating microstructures of semiconductor material, designed to overcome the drawbacks typically associated with current technology.

According to the present invention, there are provided an integrated microstructure and a method of fabricating integrated microstructures of semiconductor material, as claimed in claim 1 and in claim 12, respectively.

In practice, according to the present invention, a buried silicon oxide region is formed on the starting wafer (substrate); the epitaxial layer for integrating the integrated circuit is grown; a polycrystalline silicon region for forming the sensitive element or micromechanism is formed over the buried region; and, after forming the electronic components, the buried region is etched via trenches in the polycrystalline silicon region to form a suspended region by which to form static, kinematic or dynamic microstructures.

Two preferred, non-limiting embodiments of the present invention will be described by way of example with reference to the accompanying drawings, in which:
Figures 1-5 show cross sections of a wafer of semiconductor material at successive steps in the fabrication method according to the present invention;
Figures 6 and 7 show smaller-scale cross sections, as in Figures 1-5, at successive steps in the method according to the present invention;
Figure 8 shows a top plan view of a portion of the Figure 7 wafer;
Figure 9 shows a section, as in Figures 1-7, of a second embodiment of the fabrication method according to the present invention;
Figures 10-14 show sections, as in Figures 1-7, of a third embodiment of the present invention.

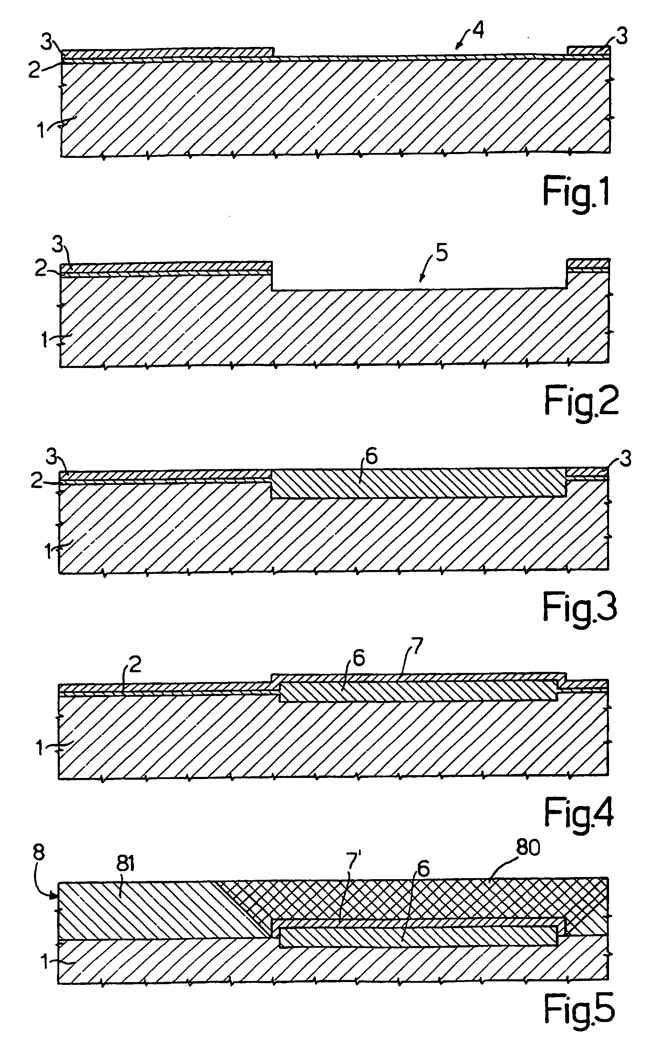

With reference to Figure 1, in the fabrication method according to the present invention, a silicon oxide layer 2 is formed, e.g. grown thermally, on a substrate 1 forming a monocrystalline silicon wafer; a silicon nitride layer 3 is deposited over oxide layer 2; a phototechnical and etching step are performed on the portion of the nitride in which the microstructure is to be formed; after removing of the resist masking layer the intermediate structure in Figure 1 is obtained in which nitride layer 3 presents a window 4.

At this point, silicon oxide layer 2 and substrate 1, masked by nitride layer 3, are etched successively to obtain the intermediate structure shown in Figure 2 in which oxide layer 2 and part of substrate 1 present a recess 5, which is subsequently filled (Figure 3) with a thermally grown oxide region 6 (hereinafter also referred to as a buried oxide region).

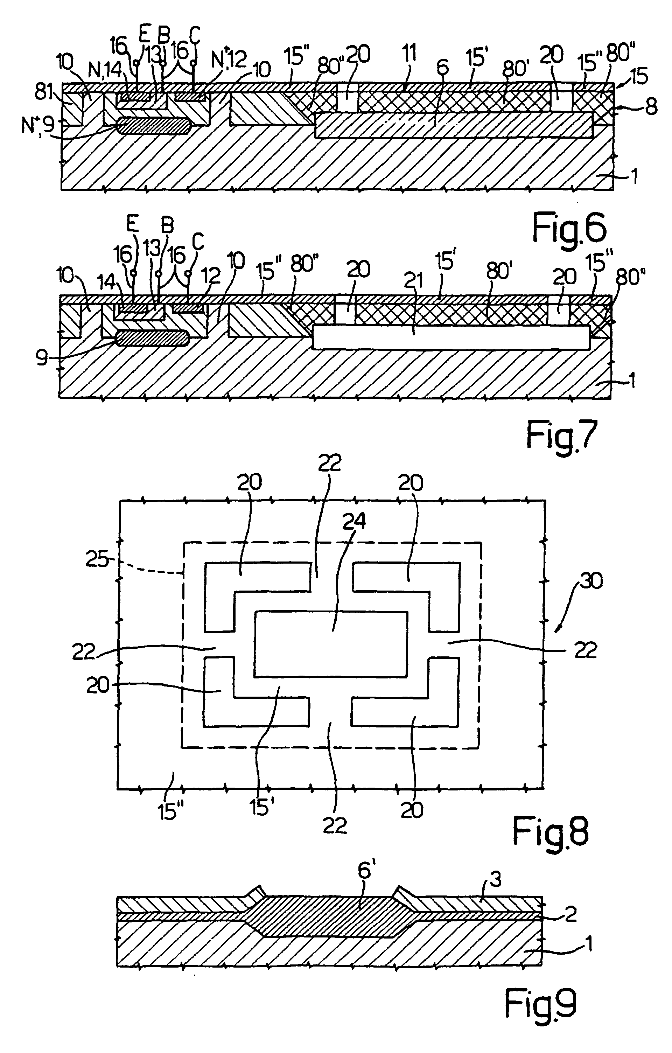

At this point, silicon nitride layer 3 is removed; an amorphous or polycrystalline silicon layer 7 is deposited, as shown in Figure 4; and, by means of a phototechnical and chemical etching step, polysilicon layer 7, with the exception of the portion over oxide region 6, and oxide layer 2 over substrate 1 are removed to obtain, over oxide region 6, a silicon region 7' representing the germ for the next step of growing the epitaxial layer. If called for in the process, doping species are implanted to form buried structures (such as buried layer 9 in Figure 6); and an epitaxial layer 8 is grown presenting a polycrystalline structure (polysilicon region 80) over buried oxide region 6, and a monocrystalline structure (epitaxial region 81) elsewhere, as shown in Figure 5.

This is followed by standard integrated circuit fabrication steps. More specifically, as shown in Figure 6, P-type junction isolation regions 10, extending from surface 11 of epitaxial layer 8 to substrate 1, and an NPN transistor, presenting an N⁺ type collector contact region 12, a P-type base region 13, and an N-type emitter region 14, are formed in N-type epitaxial layer 8. If necessary, diffused regions for implementing the microsensors, microactuators or micromechanisms provided for in the process may be formed simultaneously with the integrated circuit. For example, in known manner, when implanting the base region 13 of the NPN transistor, a heating element (not shown) may be formed in the case of a chemoresistive gas sensor, and piezoresistive elements (not shown) may be formed in the case of a pressure sensor. A dielectric layer 15 is then deposited and metal contacts 16 formed to obtain the structure shown in Figure 6, which also shows the N⁺ type buried layer 9.

At this point, the suspended structures are formed by means of a phototechnical and chemical etching step to remove portions of dielectric layer 15 and of polysilicon region 80 over buried oxide region 6, and so form a trench 20 extending from dielectric layer 15 (included) to buried oxide region 6 as shown in Figure 6. Trench 20 preferably extends in a closed line, e.g. along the sides of a rectangle (Figure 8) or along the circumference of a circle, so as to laterally define inner portions 80', 15' of polysilicon region 80 and dielectric layer 15, and separate them from respective outer portions 80", 15", with the exception of connecting and supporting arms 22 extending between inner portions 80', 15' and respective outer portions 80", 15". Trench 20 advantageously extends close to the periphery of buried oxide region 6.

Subsequently, buried oxide region 6 is removed using hydrofluoric acid to form an opening also called air gap 21 beneath inner polysilicon portion 80' (Figure 7). The inner polysilicon portion 80 thus forms a suspended region, that may be used to form structures isolated thermally or mechanically from the substrate (static structures such as chemoresistive gas or piezoresistive pressure sensors), movable structures able to detect external signals due to their movement (kinematic structures such as flow or motion sensors), or mechanical structures (dynamic structures such as micromotors or microactuators.

Before or after buried oxide region 6 is removed, regions or layers are formed according to the type of structure to be fabricated. For example, before forming trench 20, a tin oxide film 24 may be deposited and defined over inner polysilicon portion 80' and respective inner dielectric portion 15' to form a chemoresistive gas sensor shown schematically by 30 in the Figure 8 plan view, in which the dotted line 25 indicates the edge of opening 21, and which shows trench 20 separating inner and outer dielectric portions 15' and 15".

According to a further embodiment of the invention, the buried oxide region is grown directly by local oxidation, without forming recess 5 beforehand, thus eliminating etching of oxide layer 2 and substrate 1. According to this variation, shown in Figure 9, the intermediate structure in Figure 1, masked by nitride layer 3, is oxidized locally to form an oxide region 6' at window 4, and typical "beaks" beneath nitride layer 3; at which point, nitride layer 3 is removed, silicon layer 7 is deposited as shown in Figure 4, and the successive steps shown in Figures 5-8 are performed.

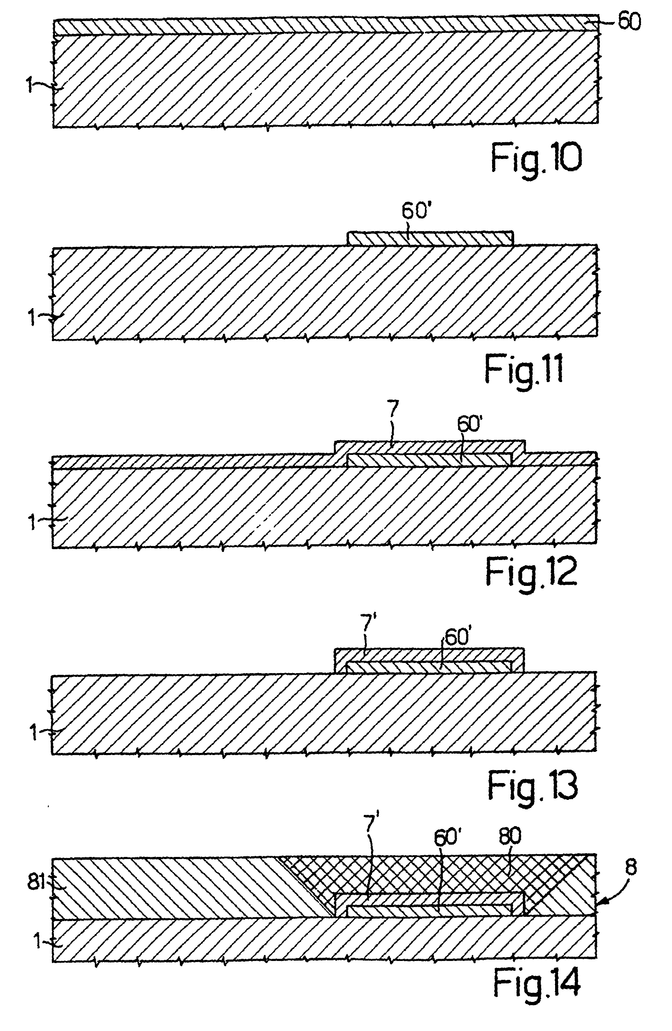

According to a third embodiment shown in Figures 10-14, the buried oxide region is formed by depositing and defining an oxide layer. More specifically, a silicon oxide layer 60 is formed, e.g. grown thermally, on substrate 1 (Figure 10); by means of known photolithographic techniques, oxide layer 60 is defined to form a region 60' (Figure 11); amorphous or polycrystalline silicon layer 7 is deposited (Figure 12); layer 7 is etched and removed, except for the portion over buried oxide region 60' (Figure 13, which shows the remaining portion 7' of silicon layer 7); the epitaxial layer is grown to give the structure in Figure 14 corresponding to Figure 5, and showing polysilicon region 80 and epitaxial region 81; and the steps described above with reference to Figures 6 and 7 are then performed.

The advantages of the fabrication method described are as follows. In particular, suspended region 80' is thicker, and therefore presents better mechanical characteristics and fewer signal processing problems as compared with deposited films. In the event the suspended structure is used to form a pressure sensor, this is more sensitive as compared with similar types formed using deposited films.

Being formed by means of an epitaxial layer, the suspended structure presents a high degree of flexural rigidity, is therefore highly unlikely to collapse and adhere to the substrate, and therefore presents better mechanical characteristics as compared with surface micromachined structures.

The suspended structure may be integrated with electronic control components on one chip; and may be formed using only three additional masks as compared with standard analog/digital fabrication processes, i.e. for defining buried oxide region 6, 6', 60', defining deposited polysilicon layer 7, and etching trench 20.

The method described is extremely low-cost as compared with those involving the use of SOI or silicon-fusion-bonded substrates.

Finally, the structure may be formed to the desired degree of flatness. That is, the embodiment in Figures 2 and 3 may be used in cases requiring a highly flat chip; and the Figure 9 and Figure 10-14 embodiments when flatness is not particularly essential.

Clearly, changes may be made to the method as described and illustrated herein without, however, departing from the scope of the present invention. In particular, isolation regions 10 in epitaxial layer 8 may be of a type other than that shown, e.g. dielectric as opposed to junction; the electronic components integrated in the same chip may be both bipolar and MOS types; the conductivity of the various regions may be other than as shown; and the structure may be used for any sensor or mechanism employing suspended regions of the type described.

## Claims

1. A method of fabricating integrated microstructures of semiconductor material comprising the sequential steps of:
- forming a sacrificial buried region (6, 6', 60') of insulating material on a substrate (1) of monocrystalline semiconductor material;
- epitaxially growing a first semiconductor material layer (8) on said substrate (1); said first semiconductor material layer consisting of a polycrystalline region (80) over said sacrificial buried region, and a monocrystalline region (81) over the monocrystalline portion of said substrate; and said substrate and said first semiconductor material layer surrounding said sacrificial buried region (6, 6', 60');
- selectively removing portions of said polycrystalline region (80) to form a trench (20) extending from a surface (11) of said first semiconductor material layer to said sacrificial buried region (6, 6', 60'); and
- removing said sacrificial buried region (6, 6', 60') via said trench (20).

2. A method as claimed in Claim 1, **characterized in that** said step of forming a sacrificial buried region comprises the steps of:
- masking said substrate (1) with a mask (3) of nonoxidizable material presenting a window (4); and
- thermally growing said sacrificial buried region (6) at said window.

3. A method as claimed in Claim 2, **characterized in that** said step of masking said substrate (1) comprises the steps of:
- forming an oxide layer (2) over said substrate (1);
- depositing a nitride layer (3) over said oxide layer; and
- defining said nitride layer to form said mask.

4. A method as claimed in Claim 3, **characterized by** the steps of:
- removing a portion of said oxide layer (2) at said window (4) following said step of masking said substrate (1); and
- removing a portion of said substrate (1) at said window to form a recess (5) in the substrate;
and in that said thermally growing step comprises the step of growing said sacrificial buried region (6) to fill said recess (5).

5. A method as claimed in Claim 2 or 3, **characterized in that** said thermally growing step comprises the step of locally oxidizing (6') said substrate (1) at said window (4).

6. A method as claimed in Claim 1, **characterized in that** said step of forming a sacrificial buried region comprises the steps of:
- growing an oxide layer (60) over said substrate (1); and
- lithographically defining (60') said oxide layer (60).

7. A method as claimed in any one of the foregoing Claims, **characterized in that** said step of growing a first semiconductor material layer (8) is preceded by the steps of:
- depositing, on said substrate (1), a second semiconductor material layer (7) covering said sacrificial buried region (6, 6', 60'); and
- selectively removing said second semiconductor material layer (7) to form a germ region (7') over said sacrificial buried region (6, 6', 60').

8. A method as claimed in Claim 7, **characterized in that** said second semiconductor material layer (7) consists of amorphous silicon.

9. A method as claimed in Claim 7, **characterized in that** said second semiconductor material layer (7) consists of polycrystalline silicon.

10. A method as claimed in any one of the foregoing claims, **characterized in that** said step of selectively removing portions of said polycrystalline region is preceded by the steps of:
- forming, in said first semiconductor material layer, regions of opposite conductivity (12-14) defining integrated electronic components;
- forming a dielectric layer (15) over said first semiconductor material layer (8); and
- forming electric contact regions (16) of electrically conductive material.

11. A method as claimed in Claim 10, **characterized in that** said step of forming electric contact regions (16) is followed by a step of forming regions (24) of a microstructure (30).

12. An integrated microstructure of semiconductor material, comprising a substrate (1) of monocrystalline semiconductor material and a semiconductor material layer (8) over said substrate, said semiconductor layer including a monocrystalline portion (81), an opening (21) being located between facing portions of said substrate (1) and of said semiconductor layer (8);
**characterized in that** said monocrystalline portion (81) directly contacts said substrate (1), that said semiconductor material layer (8) includes a polycrystalline portion (80) overlying said opening (21) and supporting integrated microsensors and microsystems (30) and that a trench (20) extends between an outer surface (11) of the polycrystalline portion of said semiconductor material layer (8) and said opening (21).

13. A microstructure as claimed in Claim 12, **characterized in that** said trench (20) defines an inner portion (80') of said polycrystalline region (80) except for connecting and supporting portions (22) extending between said inner portion (80') of said polycrystalline region and outer regions (80") of said semiconductor material layer (8).

## Patentansprüche

1. Verfahren zum Herstellen von integrierten Mikrostrukturen aus einem Halbleiterwerkstoff, welches die folgenden sequentiellen Schritte umfasst:
- Bilden eines vergrabenen Opferbereiches (6, 6', 60') aus einem Isoliermaterial auf einem Substrat (1) aus einem Einkristall-Halbleiterwerkstoff;
- Aufwachsen einer ersten Schicht (8) aus einem Halbleiterwerkstoff auf das Substrat (1); wobei die erste Halbleiterwerkstoffschicht aus einem polykristallinen Bereich (80) über dem vergrabenen Opferbereich und einem monokristallinen Bereich (81) über dem monokristallinen Abschnitt des Substrats besteht; und das Substrat und die erste Halbleiterwerkstoffschicht den vergrabenen Opferbereich (6, 6', 60') umgibt;
- selektives Entfernen von Abschnitten des polykristallinen Bereiches (80), um einen Gaben (20) zu bilden, welcher von einer Oberfläche (11) der ersten Halbleiterwerkstoffschicht zum vergrabenen Opferbereich (6, 6', 60') verläuft; und
- Entfernen des vergrabenen Opferbereiches (6, 6', 60') über den Graben (20).

2. Verfahren nach Anspruch 1, **dadurch gekennzeichnet, dass** der Schritt des Bildens eines vergrabenen Opferbereiches folgende Schritte umfasst:
- Maskieren des Substrats (1) mit einer Maske (3) aus einem nicht oxidierbaren Material, welche ein Fenster (4) darstellt; und
- thermisches Aufwachsen des vergrabenen Opferbereiches (6) am Fenster.

3. Verfahren nach Anspruch 2, **dadurch gekennzeichnet, dass** der Schritt des Maskierens des Substrats (1) folgende Schritte umfasst:
- Bilden einer Oxidschicht (2) über das Substrat (1);
- Aufdampfen einer Nitridschicht (3) über die Oxidschicht; und
- Definieren der Nitridschicht, um die Maske zu bilden.

4. Verfahren nach Anspruch 3, **gekennzeichnet durch** folgende Schritte:
- Entfernen eines Abschnitts der Oxidschicht (2) am Fenster (4) in Anschluss an den Schritt des Maskierens des Substrats (1); und
- Entfernen eines Abschnitts des Substrats (1) am Fenster, um eine Aussparung (5) im Substrat zu bilden;
und **dadurch gekennzeichnet**, dass der Schritt des thermischen Aufwachsens den Schritt des Aufwachsens des vergrabenen Opferbereiches (6) umfasst, um die Aussparung (5) zu füllen.

5. Verfahren nach Anspruch 2 oder 3, **dadurch gekennzeichnet, dass** der Schritt des thermischen Aufwachsens den Schritt des lokalen Oxidierens (6') des Substrats (1) am Fenster (4) umfasst.

6. Verfahren nach Anspruch 1, **dadurch gekennzeichnet, dass** der Schritt zum Bilden eines vergrabenen Opferbereiches folgende Schritte umfasst:
- Aufwachsen einer Oxidschicht (60) über das Substrat (1); und
- lithografisches Bestimmen (60') der Oxidschicht (60).

7. Verfahren nach einem der vorangehenden Ansprüche,
**dadurch gekennzeichnet, dass** der Schritt des Aufwachsens einer ersten Halbleiterwerkstoffschicht (8) im Anschluss an die folgenden Schritten folgt:
- Aufdampfen einer zweiten Schicht (7) aus einem Halbleiterwerkstoff auf das Substrat (1), welche den vergrabenen Opferbereich (6, 6', 60') bedeckt; und
- selektives Entfernen der zweiten Halbleiterwerkstoffschicht (7), um einen Keimbereich (7') über dem vergrabenen Opferbereich (6, 6', 60') zu bilden.

8. Verfahren nach Anspruch 7, **dadurch gekennzeichnet, dass** die zweite Halbleiterwerkstoffschicht (7) aus amorphen Silizium besteht.

9. Verfahren nach Anspruch 7, **dadurch gekennzeichnet, dass** die zweite Halbleiterwerkstoffschicht (7) aus polykristallinen Silizium besteht.

10. Verfahren nach einem der vorangehenden Ansprüche,
**dadurch gekennzeichnet, dass** der Schritt des selektiven Entfernens von Abschnitten des polykristallinen Bereiches im Anschluss an die folgenden Schritten folgt:
- Bilden von Bereichen entgegengesetzter Leitfähigkeit (12-14) in der ersten Halbleiterwerkstoffschicht, welche integrierte elektronische Bauelemente definieren;
- Bilden einer dielektrischen Schicht (15) über der Halbleiterwerkstoffschicht (8); und
- Bilden elektronischer Kontaktbereiche (16) aus einem elektrisch leitfähigem Material.

11. Verfahren nach Anspruch 10, **dadurch gekennzeichnet, dass** der Schritt zum Formen elektrischer Kontaktbereiche (24) von einem Schritt zum Formen von Bereichen (24) aus einer Mikrostruktur (30) gefolgt wird.

12. Integrierte Mikrostruktur aus einem Halbleiterwerkstoff, welche ein Substrat (1) aus einem Einkristall-Halbleiterwerkstoff und eine Halbleiterwerkstoffschicht (8) über dem Substrat aufweist, wobei die Halbleiterwerkstoffschicht einen monokristallinen Abschnitt (81) und eine zwischen den sich gegenüberliegenden Abschnitten des Substrats (1) und der Halbleiterwerkstoffschicht (8) angeordnete Öffnung (21) enthält;
**dadurch gekennzeichnet, dass** der monokristalline Abschnitt (81) das Substrat direkt berührt, dass die Halbleiterwerkstoffschicht (8) einen polykristallinen Abschnitt (80) enthält, welcher über der Öffnung (21) liegt und integrierte Mikrosensoren und Mikrosysteme (30) mitführt, und dass ein Graben (20) zwischen einer Außenfläche (11) des polykristallinen Abschnitts der Halbleiterwerkstoffschicht (8) und der Öffnung (21) verläuft.

13. Mikrostruktur nach Anspruch 12, **dadurch gekennzeichnet, dass** der Graben (20) einen inneren Abschnitt (80') des polykristallinen Abschnitts (80) mit Ausnahme der verbindenden und stützenden Abschnitte (22) definiert, welche zwischen dem inneren Abschnitt (80') des polykristallinen Bereichs und den äußeren Abschnitten (80'') der Halbleiterwerkstoffschicht (8) verlaufen.

## Revendications

1. Procédé pour fabriquer des microstructures intégrées en matériau semi-conducteur comportant les étapes séquentielles consistant à :
- former une région enterrée sacrificielle (6, 6', 60') de matériau isolant sur un substrat (1) d'un matériau semi-conducteur monocristallin ;
- faire croître de manière épitaxiale une première couche de matériau semi-conducteur (8) sur ledit substrat (1), ladite première couche de matériau semi-conducteur consistant en une région polycristalline (80) sur ladite région enterrée sacrificielle, et une région monocristalline (81) sur la partie monocristalline dudit substrat, et ledit substrat et ladite première couche de matériau semi-conducteur entourant ladite couche enterrée sacrificielle (6, 6', 60') ;
- retirer de manière sélective des parties de ladite région polycristalline (80) pour former une tranchée (20) s'étendant depuis une surface (11) de ladite première couche de matériau semi-conducteur jusqu'à ladite région enterrée sacrificielle (6, 6', 60') ; et
- retirer ladite région enterrée sacrificielle (6, 6', 60') via ladite tranchée (20).

2. Procédé selon la revendication 1, **caractérisé en ce que** ladite étape de formation d'une région enterrée sacrificielle comporte les étapes consistant à :
- masquer ledit substrat (1) à l'aide d'un masque (3) en matériau non-oxydable présentant une fenêtre (4) ; et
- faire croître thermiquement ladite région enterrée sacrificielle (6) au niveau de ladite fenêtre.

3. Procédé selon la revendication 2, **caractérisé en ce que** ladite étape de masquage dudit substrat (1) comporte les étapes consistant à :
- former une couche d'oxyde (2) sur ledit substrat (1) ;
- déposer une couche de nitrure (3) sur ladite couche d'oxyde ; et
- définir ladite couche de nitrure pour former ledit masque.

4. Procédé selon la revendication 3, **caractérisé par** les étapes consistant à :
- retirer une partie de ladite couche d'oxyde (2) au niveau de ladite fenêtre (4) après ladite étape de masquage dudit substrat (1) ; et
- retirer une partie dudit substrat (1) au niveau de ladite fenêtre pour former un évidement (5) dans le substrat ;
et en ce que ladite étape de croissance thermique comporte l'étape de croissance de ladite région enterrée sacrificielle (6) pour remplir ledit évidement (5).

5. Procédé selon la revendication 2 ou 3, **caractérisé en ce que** ladite étape de croissance thermique comporte l'étape d'oxydation locale (6') dudit substrat (1) au niveau de ladite fenêtre (4).

6. Procédé selon la revendication 1, **caractérisé en ce que** ladite étape de formation d'une couche enterrée sacrificielle comporte les étapes consistant à :
- faire croître une couche d'oxyde (60) sur ledit substrat (1) ; et
- définir de manière lithographique (60') ladite couche d'oxyde (60).

7. Procédé selon l'une quelconque des revendications précédentes, **caractérisé en ce que** ladite étape de croissance d'une première couche de matériau semi-conducteur (8) est précédée des étapes consistant à :
- déposer, sur ledit substrat (1), une seconde couche de matériau semi-conducteur (7) recouvrant ladite région enterrée sacrificielle (6, 6', 60') ; et
- retirer de manière sélective ladite seconde couche de matériau semi-conducteur (7) pour former une région de germe (7') sur ladite région enterrée sacrificielle (6, 6', 60').

8. Procédé selon la revendication 7, **caractérisé en ce que** ladite seconde couche de matériau semi-conducteur (7) consiste en du silicium amorphe.

9. Procédé selon la revendication 7, **caractérisé en ce que** ladite seconde couche de matériau semi-conducteur (7) consiste en du silicium polycristallin.

10. Procédé selon l'une quelconque des revendications précédentes, **caractérisé en ce que** ladite étape de retrait de manière sélective des parties de ladite région polycristalline est précédée des étapes consistant à :
- former, dans ladite première couche de matériau semi-conducteur, des régions de conductivité opposée (12-14) définissant des composants électroniques intégrés ;
- former une couche diélectrique (15) sur ladite première couche de matériau semi-conducteur (8) ; et
- former des régions de contact électrique (16) dans du matériau électriquement conducteur.

11. Procédé selon la revendication 10, **caractérisé en ce que** ladite étape de formation de régions de contact électrique (16) est suivie d'une étape de formation de régions (24) d'une microstructure (30).

12. Microstructure intégrée en matériau semi-conducteur, comportant un substrat (1) de matériau semi-conducteur monocristallin et une couche de matériau semi-conducteur (8) sur ledit substrat, ladite couche de matériau semi-conducteur incluant une partie monocristalline (81), une ouverture (21) étant positionnée entre des parties en vis-à-vis dudit substrat (1) et de ladite couche de matériau semi-conducteur (8),
**caractérisée en ce que** ladite partie monocristalline (81) vient directement en contact avec ledit substrat (1), **en ce que** ladite couche de matériau semi-conducteur (8) inclut une partie polycristalline (80) sus-jacente à ladite ouverture (21) et supportant des microcapteurs et microsystèmes intégrés (30) et **en ce qu'**une tranchée (20) s'étend entre une surface extérieure (11) de la partie polycristalline de ladite couche de matériau semi-conducteur (8) et ladite ouverture (21).

13. Microstructure selon la revendication 12, **caractérisée en ce que** ladite tranchée (20) définit une partie intérieure (80') de ladite région polycristalline (80) à l'exception de parties de connexion et de support (22) s'étendant entre ladite partie intérieure (80') de ladite région polycristalline et des régions extérieures (80") de ladite couche de matériau semi-conducteur (8).
